# EUROPÄISCHE PATENTSCHRIFT

(11) **EP 2 185 952 B1**
(45) Veröffentlichungstag und Bekanntmachung des Hinweises auf die Patenterteilung: **12.12.2018**
(21) Anmeldenummer: 08801176.2
(22) Anmeldetag: 14.08.2008
(51) Int. Cl.: G02B 1/12, G02B 1/04, G02B 1/10, G02B 27/00, C08J 7/12, H01L 33/56

(54) **OPTISCHES BAUTEIL, VERFAHREN ZUR HERSTELLUNG DES BAUTEILS UND OPTOELEKTRONISCHES BAUELEMENT MIT DEM BAUTEIL**
OPTICAL COMPONENT, METHOD FOR PRODUCING SAID COMPONENT, AND OPTOELECTRONIC ASSEMBLY UNIT COMPRISING SAID COMPONENT
COMPOSANT OPTIQUE, PROCÉDÉ DE PRODUCTION DE CE COMPOSANT ET ÉLÉMENT OPTO-ÉLECTRONIQUE COMPRENANT CE COMPOSANT

(30) Priorität: 04.09.2007 DE 102007041889; 31.10.2007 DE 102007052133
(43) Veröffentlichungstag der Anmeldung: 19.05.2010
(73) Patentinhaber: OSRAM Opto Semiconductors GmbH, 93055 Regensburg (DE)
(72) Erfinder: KRÄUTER, Gertrud, 93051 Regensburg (DE); PIETZONKA, Torsten, 93093 Donaustauf (DE)
(74) Vertreter: Epping - Hermann - Fischer
(86) Internationale Anmeldenummer: PCT/DE2008/001353
(87) Internationale Veröffentlichungsnummer: WO 2009/030193

(56) Entgegenhaltungen:
- WO-A-03/076512
- DE-A1-102004 019 973
- JP-A- S55 099 932
- US-A1- 2006 222 970

## Beschreibung

Die Erfindung betrifft ein als Verguss oder Linse ausgeformtes optisches Bauteil für ein optoelektronisches Bauelement, ein Verfahren zu dessen Herstellung und ein optoelektronisches Bauelement, das ein solches Bauteil umfasst.

Diese Patentanmeldung beansprucht die Priorität der deutschen Patentanmeldungen 10 2007 041 889.4 und 10 2007 052 133.4.

In optoelektronischen Bauelementen können optische Bauteile vorhanden sein, die klebrige Oberflächen aufweisen. Solche Oberflächen führen dazu, dass Verunreinigungen oder Partikel, wie z. B. Staub, auf ihnen anhaften oder dass die Bauteile selbst an anderen Bauteilen anhaften. Solche Anhaftungen können zu Qualitätsproblemen führen.

DE 10 2004 019973 A1 und JP 55-099932 A offenbaren als Verguss oder Linse ausgeformte optische Bauteile aus Harzformstoffen, die zwecks Verringerung der Oberflächenhaftung einer Oberflächenbehandlung unterworfen wurden.

Aufgabe der Erfindung ist es, ein optisches Bauteil bereitzustellen, das bezüglich der oben genannten Nachteile verbessert ist.

Diese Aufgabe wird durch ein optisches Bauteil gemäß Anspruch 1 gelöst. Ein Verfahren zur Herstellung dieses Bauteils und ein optoelektronisches Bauelement aufweisend dieses Bauteil sind Gegenstand weiterer Ansprüche.

Ein optisches Bauteil gemäß einer bevorzugten Ausführungsform der Erfindung ist in Anspruch 1 angegeben.

Die haftungsvermindernde Oberflächenschicht ist chemisch modifiziert. Ein solches optisches Bauteil vermindert somit Verunreinigungen durch Partikelanhaftungen.

Das Bauteil kann aus dem gleichen Harzformstoff ausgeformt sein, wie die Oberflächenschicht, wobei der Harzformstoff der Oberflächenschicht chemisch modifiziert ist. Somit muss keine zusätzliche Schicht auf dem Bauteil angeordnet werden, sondern nur die Oberflächenschicht des Harzformstoffs durch chemische Modifizierung hergestellt werden. Das optische Bauteil kann beispielsweise haftungsvermindernd für Staubpartikel sein.

Ein optisches Bauteil kann eine Wechselwirkung mit Licht eingehen und somit optisch aktiv oder optisch manipulierend sein. Somit kann ein optisches Bauteil Licht formend, Licht führend oder Licht umwandelnd wirken. Ein optisches Bauteil kann seine optische Wirkung zum Beispiel in Form von Streuung, Brechung, Reflexion, Umlenkung und Beugung zeigen.

Das optische Bauteil kann transparent oder reflektierend für Strahlung sein. Dadurch kann es in optoelektronischen Bauelementen eingesetzt werden. Ein transparentes Bauteil kann dort im Strahlengang von emittierter oder empfangener Strahlung angeordnet sein.

Das Bauteil ist als Verguss oder als Linse ausgeformt. Dadurch eignet es sich für den Einsatz als optisches Bauteil in beispielsweise optoelektronischen Bauelementen. Wenn das Bauteil als Verguss ausgeformt ist, kann es beispielsweise als Verguss für Halbleiterschichtenfolgen verwendet werden.

Linsen, die einen Harzformstoff mit der haftungsvermindernden Oberflächenschicht aufweisen, sind besonders temperatur- und strahlungsstabil und transparent für die emittierte und empfangene Strahlung.

Der Harzformstoff, der in dem optischen Bauteil vorhanden ist, ist Silikonharz. Dieses Material ist transparent und eignet sich zur Ausformung als Verguss oder Linsen.

Es wird weiterhin ein Verfahren zur Herstellung eines optischen Bauteils mit den oben beschriebenen Eigenschaften bereitgestellt. Ein solches Verfahren umfasst die in Anspruch 5 definierten Verfahrensschritte. Dieses Verfahren kann gezielt und relativ einfach umgesetzt werden.

Bei dem Verfahren wird im Verfahrensschritt A) ein Harzformstoff bereitgestellt, der ein Silikonharz ist. Im Verfahrensschritt B) wird der Harzformstoff als Linse oder als Verguss ausgeformt. Zur Ausformung kann beispielsweise ein Spritzgussverfahren oder Vergießen verwendet werden. Dadurch kann gezielt die gewünschte Form des Bauteils hergestellt werden.

Im Verfahrensschritt C) wird zur Herstellung der haftungsvermindernden Oberflächenschicht die Oberflächenschicht des

Harzformstoffs chemisch modifiziert. Zur chemischen Modifizierung im Verfahrensschritt C) wird der Harzformstoff einem Plasma ausgesetzt Das Plasma enthält fluorhaltige Verbindungen, die aus einer Gruppe ausgewählt sein können, die CF₄, C₂F₆, NF₃ und SF₆ umfasst. Diese Verbindungen enthalten Fluor, das dazu dient, das Silikonharz oder das Epoxidharz zu fluorieren. So können die im Harzformstoff enthaltenen Kohlenstoffatome fluoriert werden. Dadurch entstehen teflonartige Verbindungen, die eine dünne Schicht mit einer Dicke von weniger als 50 nm an der Oberfläche des Harzformstoffes bilden. Das Plasma, das die fluorhaltigen Verbindungen enthält, kann weiterhin ein Inertgas, wie beispielsweise Argon, enthalten und somit die fluorhaltigen Verbindungen je nach Bedarf verdünnen. Das Verhältnis von Argon zu den fluorhaltigen Verbindungen kann dabei zwischen 1:9 und 9:1 liegen. Der Harzformstoff kann für 1 bis 30 Minuten, vorzugsweise für 5 bis 30 Minuten, dem Plasma ausgesetzt werden. Dies kann bei Raumtemperatur geschehen, wobei sich der Harzformstoff auf bis zu 40°C bis 50°C während der Behandlung mit dem Plasma erwärmen kann. Das Plasma kann ein Niederdruckplasma umfassen, sodass der Harzformstoff bei einem Druck von etwa 0,1 mbar dem Plasma ausgesetzt ist.

Es ist weiterhin möglich, dass die fluorhaltigen Verbindungen während der Plasmabehandlung polymerisieren und als zusätzliche Schicht auf der modifizierten Oberflächenschicht des Harzformstoffs abgeschieden werden. Die zusätzliche Schicht kann teflonartig sein und eine Dicke von weniger als 50 nm aufweisen.

Es wird weiterhin ein optoelektronisches Bauelement, aufweisend eine strahlungsemittierende oder strahlungsempfangende Halbleiterschichtenfolge und ein optisches Bauteil mit den oben beschriebenen Eigenschaften, bereitgestellt. Dabei ist das optische Bauteil im Strahlengang der emittierten oder empfangenen Strahlung angeordnet. Das optoelektronische Bauelement umfasst ein optisches Bauteil, das als Linse ausgeformt ist, oder ein optisches Bauteil, das als Verguss ausgeformt ist. Das optoelektronische Bauelement kann eine Halbleiterschichtenfolge umfassen, wobei der Verguss die Halbleiterschichtenfolge verkapselt. Die Halbleiterschichtenfolge kann beispielsweise eine lichtemittierende Diode (LED) sein.

Anhand der Figuren soll die Erfindung näher erläutert werden:
- Figur 1a: zeigt eine schematische Seitenansicht einer Ausführungsform des optoelektronischen Bauelements mit dem optischen Bauteil.
- Figur 1b: zeigt eine schematische Seitenansicht einer weiteren Ausführungsform des optoelektronischen Bauelements mit dem optischen Bauteil.
- Figur 2: zeigt Aufnahmen von optischen Bauteilen, die Verunreinigungen ausgesetzt wurden.

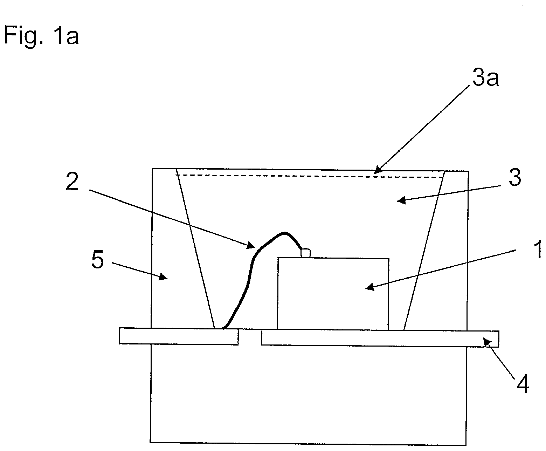

Figur 1a zeigt die schematische Seitenansicht eines optoelektronischen Bauelements. Dieses umfasst eine Halbleiterschichtenfolge 1, die beispielsweise eine LED sein kann und sowohl direkt also auch über einen Bonddraht 2 mit jeweils einem Leiterband 4 elektronisch kontaktiert ist. Die Halbleiterschichtenfolge sowie der Bonddraht sind von dem Verguss 3 umgeben, der sich in dem Gehäuse 5 befindet. Das Gehäuse 5 kann abgeschrägte Seitenflächen aufweisen, die zu einer verbesserten Reflexion der abgegebenen Strahlung dienen. Der

Verguss 3 ist aus einem Harzformstoff geformt, der Silikonharze umfasst und mit einem Plasma, das fluorhaltige Verbindungen enthält, behandelt wurde, sodass er eine Oberflächenschicht 3a aufweist, die haftungsvermindernd für Verunreinigungen wie beispielsweise Staubpartikel ist.

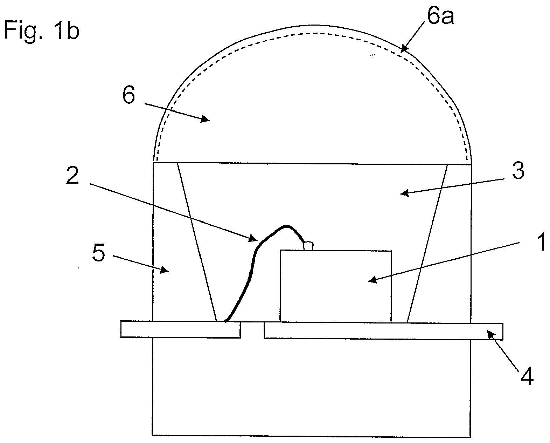

Auf dem Gehäuse und dem Verguss kann sich eine Linse 6 befinden, was in Figur 1b gezeigt ist. Die Linse 6 weist einen Harzformstoff auf der Silikonharze umfasst. Auch der als Linse ausgeformte Harzformstoff ist mit einem Verfahren behandelt worden in dem die Linse einem Plasma mit fluorhaltigen Verbindungen ausgesetzt wird. Somit hat auch die Linse eine haftungsvermindernde Oberflächenschicht 6a, die fluorierte Verbindungen aufweist und haftungsvermindernd für Verunreinigungen wie z. B. Staub ist.

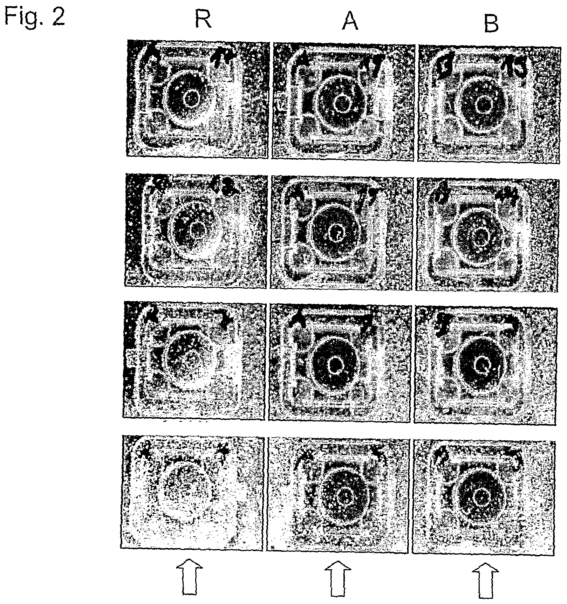

Figur 2 zeigt Aufnahmen von Linsen, die aus einem Harzformstoff geformt wurden und noch nicht auf optoelektronische Bauelemente montiert sind. Die Linsen wurden nebeneinander auf einem Halter aufgebracht. Die Anordnung der einzelnen Aufnahmen in Figur 2 entspricht der Anordnung der Linsen auf dem Halter. Die Linsen in der ersten Spalte R sind Silikonharz-Linsen, die eine nicht behandelte Oberfläche aufweisen. Die Linsen der zweiten Spalte A und der dritten Spalte B sind Silikonharz-Linsen aus zwei Herstellungschargen, die mit einem CF₄-Plasma entsprechend dem oben beschriebenen Verfahren behandelt wurden und somit haftungsvermindernde Oberflächenschichten aufweisen. Von unten her wurden die Linsen mit Feinstaub-Partikeln, die in Epoxidharz eingegossenes Glasfasergewebe umfassen, bestaubt, was in Figur 2 durch Pfeile angedeutet ist. In allen Spalten ist somit in der untersten Reihe am meisten Feinstaub auf den Linsen vorhanden und nimmt mit größerem Abstand von der Staubquelle, also in den oberen Reihen, ab. In der Spalte R mit den Linsen, die eine unbehandelte Oberfläche haben, ist jedoch eine deutlich höhere Staubkonzentration zu sehen (weiße Flächen), als in den Reihen A und B mit den behandelten Linsen. Somit kann gezeigt werden, dass die Behandlung der Oberflächen der Linsen zu einer haftungsvermindernden Oberflächenschicht und damit zu für Verunreinigungen weniger anfälligen Bauteilen führt.

Die in den Figuren 1 und 2 gezeigten Beispiele und Ausführungsformen können im Rahmen der anhängenden Ansprüche variiert werden. Es ist weiterhin zu berücksichtigen, dass sich die Erfindung nicht auf diese Beispiele beschränkt, sondern weitere, hier nicht aufgeführte Ausgestaltungen zulässt. Die Erfindung ist in den anhängenden Ansprüchen definiert.

## Patentansprüche

1. Optisches Bauteil ausgeformt als Verguss oder Linse für ein eine LED umfassendes optoelektronisches Bauelement, umfassend einen Harzformstoff, der mit einem Plasma, das fluorhaltige Verbindungen enthält, behandelt ist, so dass die in einer Oberflächenschicht (3a, 6a) des Harzformstoffs enthaltenen Kohlenstoffatome fluoriert werden und der Harzformstoff eine chemisch modifizierte, haftungsvermindernde Oberflächenschicht (3a, 6a) mit teflonartigen Verbindungen aufweist und der Harzformstoff ein Silikonharz ist.

2. Bauteil nach dem vorhergehenden Anspruch, wobei die Oberflächenschicht (3a, 6a) aus dem gleichen Harzformstoff ausgeformt ist wie das Bauteil und der Harzformstoff der Oberflächenschicht chemisch modifiziert ist.

3. Bauteil nach einem der vorhergehenden Ansprüche, wobei die Oberflächenschicht (3a, 6a) haftungsvermindernd für Staubpartikel ist.

4. Bauteil nach einem der vorhergehenden Ansprüche, wobei das Bauteil transparent oder reflektierend für Strahlung ist.

5. Verfahren zur Herstellung eines optischen Bauteils gemäß den Ansprüchen 1 bis 4 mit den Verfahrensschritten
A) Bereitstellen des Harzformstoffs,
B) Ausformen des Harzformstoffs zu dem optischen Bauteil,
C) Herstellung einer chemisch modifizierten, haftungsvermindernden Oberflächenschicht (3a, 6a) des Harzformstoffs auf dem optischen Bauteil durch Aussetzen des Harzformstoffs mit einem Plasma, das fluorhaltige Verbindungen enthält.

6. Optoelektronisches Bauelement aufweisend eine strahlungsemittierende oder strahlungsempfangende Halbleiterschichtenfolge und ein optisches Bauteil gemäß den Ansprüchen 1 bis 4 im Strahlengang der emittierten oder empfangenen Strahlung.

## Claims

1. An optical device formed as a potting or lens for an LED-comprising optoelectronic device, comprising a resin moulding compound treated with a plasma containing fluorine-containing compounds,
so that the carbon atoms contained in a surface layer (3a, 6a) of the resin moulding compound are fluorinated and the resin moulding compound comprises a chemically modified, adhesion-reducing surface layer (3a, 6a) with teflon-like compounds,
and the resin moulding compound is a silicone resin.

2. Device according to the preceding claim, the surface layer (3a, 6a) being formed of the same resin moulding compound as the device, and the resin moulding compound of the surface layer being chemically modified.

3. Device according to any one of the preceding claims, the surface layer (3a, 6a) being adhesion-reducing for dust particles.

4. Device according to any one of the preceding claims, the device being transparent or reflecting for radiation.

5. Method of producing an optical device according to claims 1 to 4, comprising the steps of
A) providing the resin moulding compound,
B) forming the resin moulding compound into the optical device,
C) producing a chemically modified, adhesion-reducing surface layer (3a, 6a) of the resin moulding compound on the optical device by exposing the resin moulding compound to a plasma containing fluorine-containing compounds.

6. Optoelectronic component having a radiation-emitting or radiation-receiving semiconductor layer sequence and an optical device according to claims 1 to 4 in the beam path of the emitted or received radiation.

## Revendications

1. Pièce optique formée en tant qu'enrobage ou lentille pour un composant optoélectronique comprenant une DEL, comprenant une matière de moulage à base de résine qui est traitée avec un plasma contenant des composés fluorés de telle sorte que les atomes de carbone contenus dans une couche superficielle (3a, 6a) de la matière de moulage à base de résine sont fluorés, la matière de moulage à base de résine présente une couche superficielle (3a, 6a) modifiée chimiquement, réduisant l'adhérence et à composés de style Téflon, et la matière de moulage à base de résine est une résine de silicones.

2. Pièce selon la revendication précédente, la couche superficielle (3a, 6a) étant constituée de la même matière de moulage à base de résine que la pièce, et la matière de moulage à base de résine de la couche superficielle est modifiée chimiquement.

3. Pièce selon l'une quelconque des revendications précédentes, la couche superficielle (3a, 6a) réduisant l'adhérence des particules de poussière.

4. Pièce selon l'une quelconque des revendications précédentes, la pièce étant transparente ou réfléchissante au rayonnement.

5. Procédé de fabrication d'une pièce optique selon les revendications 1 à 4 avec les étapes de procédé
A) fourniture de la matière de moulage à base de résine,
B) mise en forme de la matière de moulage à base de résine dans le pièce optique,
C) fabrication d'une couche superficielle (3a, 6a) de la matière de moulage à base de résine, modifiée chimiquement et réduisant l'adhérence, sur la pièce optique par mouillage de la matière de moulage à base de résine avec un plasma qui contient des composés fluorés.

6. Composant optoélectronique présentant une succession de couches semi-conductrices émettant un rayonnement ou captant un rayonnement et une pièce optique selon les revendications 1 à 4 dans la trajectoire du rayonnement émis ou capté.
